# EUROPEAN PATENT APPLICATION

(11) **EP 4 566 985 A1**
(43) Date of publication of application: **11.06.2025**
(21) Application number: 24213895.6
(22) Date of filing: 19.11.2024
(51) Int. Cl.: B81B 7/02

(54) **PROCESS FOR MANUFACTURING A COMBINED MICROELECTROMECHANICAL DEVICE WITH A REDUCED CROSS-TALK AND CORRESPONDING COMBINED MICROELECTROMECHANICAL DEVICE**

(30) Priority: 05.12.2023 IT 202300025983
(71) Applicant: STMicroelectronics International N.V., 1228 Geneva Plan-les-Ouates (CH)
(72) Inventor: GUERRA, Anna, 24048 Treviolo (BG) (IT); CORSO, Lorenzo, 20871 Ruginello (MB) (IT); VERCESI, Federico, 20134 Milano (IT); LUBERTO, Alessandro, 20141 Milano (IT); ALLEGATO, Giorgio, 20900 Monza (MB) (IT)
(74) Representative: Studio Torta S.p.A.

(57) **Abstract**

A process for manufacturing a combined microelectromechanical device (20) envisages: forming, in a sensor wafer (14), at least a first (16) and a second (17) microelectromechanical structures, at a main surface (14a); forming, in a cap wafer (1), at least a first (8) and a second (9) cavities, at a respective main surface (1a); forming a getter region (12) inside the first cavity; bonding the main surfaces of the sensor and cap wafers by means of a bonding region (10), to define a first and a second hermetic environments for the microelectromechanical structures at different pressure values. A raised frame (6) is formed, before the bonding step, in such a way as to be located around the first cavity; the bonding region determines the bonding of the sensor and cap wafers at the raised frame and the definition of the first hermetic environment associated with the first cavity, in a time interval prior to hermetic closure of the second cavity (9).

## Description

### TECHNICAL FIELD

The present solution relates to a process for manufacturing a microelectromechanical (made using MEMS - Micro-Electro-Mechanical System - technology) combined device, so-called "combo", having a reduced cross-talk; the present solution also relates to a corresponding combined microelectromechanical device.

### BACKGROUND

Combined MEMS devices are known, i.e. including at least a first and a second microelectromechanical structures, for example a first and a second sensing structures defining a first and a second sensors, arranged in a same semiconductor material die, typically in a side-by-side arrangement in a horizontal plane of main extension of the same die.

Using combined MEMS devices is particularly advantageous, for example in terms of area occupation and optimization of electrical connections (compared to the case of manufacturing of the individual sensors in respective semiconductor material dies with the need to provide the electrical connections between the same dies and a coupled electronic circuit).

In particular, combined MEMS devices defining Inertial Measuring Units, IMUs, are known, comprising in a same die of semiconductor material at least two different sensors with multiple detection axes, for example at least an accelerometer and a gyroscope, both of the triaxial type, to provide information on both acceleration and angular speed of a body or object to which they are applied.

For example, such devices are widely used in mobile or wearable devices (such as smartphones, tablets, smart watches or the like) or in automotive or industrial applications.

In a known manner, the accelerometer and gyroscope comprise respective mobile structures, elastically suspended with respect to a common substrate formed in the semiconductor material die and housed in a respective hermetic cavity, typically defined by bonding a cap to the same substrate; this cap, in particular, defines a ceiling for the hermetic cavities of the sensing structures of the sensors.

Furthermore, the need to define different operating conditions for the microelectromechanical structures of the combined MEMS devices is known, in particular as to different pressure values inside the respective hermetic cavities. For example, for its optimal operation, an accelerometer requires high pressure values (of the order of thousands of Pa, for example around 0.01 MPa) for damping of the corresponding structure, which is mobile due to inertial effect; while a gyroscope requires, again for its optimal operation, low pressure values (of the order of a few hundreds of Pa, for example around 100 Pa), to ensure effective driving of the corresponding mobile structure. In this case, therefore, the pressure within the hermetic cavity where the accelerometer is arranged is required to be different from, in particular greater than, the pressure within the respective hermetic cavity where the gyroscope is housed.

From the point of view of the manufacturing process, the aforementioned need to define different pressure values inside the respective hermetic cavities in the combined MEMS device causes some implementation issues.

A first known solution envisages, in this regard, using a getter region, which is introduced into at least one of the hermetic cavities (for example being coupled to the ceiling of the cap), so as to adjust the pressure within the same hermetic cavity in a desired manner.

In particular, after bonding the cap to the common substrate, the hermetic cavities of the different microelectromechanical structures are at a same pressure, due to the bonding process and the processing gases used; in this case, activation of the getter region allows the pressure inside the cavity in which it is inserted to be reduced, attracting the non-noble gas species present in the same cavity.

Although effective in forming the hermetic cavities of microelectromechanical structures at different pressures, this solution has the drawback of being subject to a possible cross-talk (i.e. to a mutual interference) between the same hermetic cavities.

In particular, the getter region, during the bonding process between the cap and the substrate, may also attract gases coming from the cavity in which the same getter region is not present, modifying the final pressure value of the same cavity.

In essence, the final pressure value in the cavities may be subject to a certain degree of tolerance with respect to a desired pressure set point and, during operation, this tolerance may lead to a lower accuracy of the sensing signals provided by the microelectromechanical structures.

A second known solution, described for example in US 10,017,380 B1 or in US 9,919,919 B2, envisages definition of a "chimney" or access channel through the cap (after its bonding to the common substrate) in correspondence with at least one of the hermetic cavities, whose pressure is desired to be controlled in a distinct manner with respect to at least one other cavity.

Through this access channel, the pressure internal to the cavity is adjusted in a desired manner, for example by introducing a flow of gas having a controlled pressure; afterwards, the same access channel is suitably sealed in the same pressure-controlled environment, for example by deposition or laser melting techniques.

However, this solution also has some issues. For example, hermetically closing the access channel requires complex additional operations, in particular as to the laser melting step, which entail an increase in costs and times of the manufacturing process.

### SUMMARY

The aim of the present disclosure is therefore to provide a solution for manufacturing a combined microelectromechanical device that allows the issues previously highlighted to be overcome.

According to the present solution, a process for manufacturing a combined microelectromechanical device and a corresponding combined microelectromechanical device are provided, as defined in the attached claims.

### BRIEF DESCRIPTION OF THE FIGURES

For a better understanding of the present invention, preferred embodiments thereof are now described, purely by way of non-limiting example, with reference to the attached drawings, wherein:
- Figures 1A-1G are schematic sectional views of a combined microelectromechanical device, in successive steps of a corresponding manufacturing process, according to an embodiment of the present solution;
- Figure 2 shows a schematic plan view of a possible layout of a cap wafer of the combined microelectromechanical device;
- Figures 3A-3E are schematic sectional views of a combined microelectromechanical device, in successive steps of a corresponding manufacturing process, in accordance with a different embodiment of the present solution; and
- Figure 4 is a schematic block diagram of an electronic apparatus, including the combined microelectromechanical device.

### DESCRIPTION OF EMBODIMENTS

In general, and as will be described in detail below, one aspect of the present solution envisages the formation, before bonding of a common substrate having the different microelectromechanical structures formed therein to a corresponding cap (which contributes to definition of the cavities associated with the microelectromechanical structures), of a raised frame at, in particular around, the cavity whose pressure is desired to be controlled by means of a getter region.

In this manner, when the cap is coupled to the common substrate, bonding first occurs at this raised frame, sealing the aforementioned cavity (with the other cavities still open to the external environment); consequently, the getter region activates in a localized manner inside this cavity, reducing the possibility of interference (cross-talk) with the other cavities.

A first embodiment of a combined microelectromechanical (MEMS) device is now described, which envisages the formation of the aforementioned raised frame on the cap, before bonding the same cap to the common substrate.

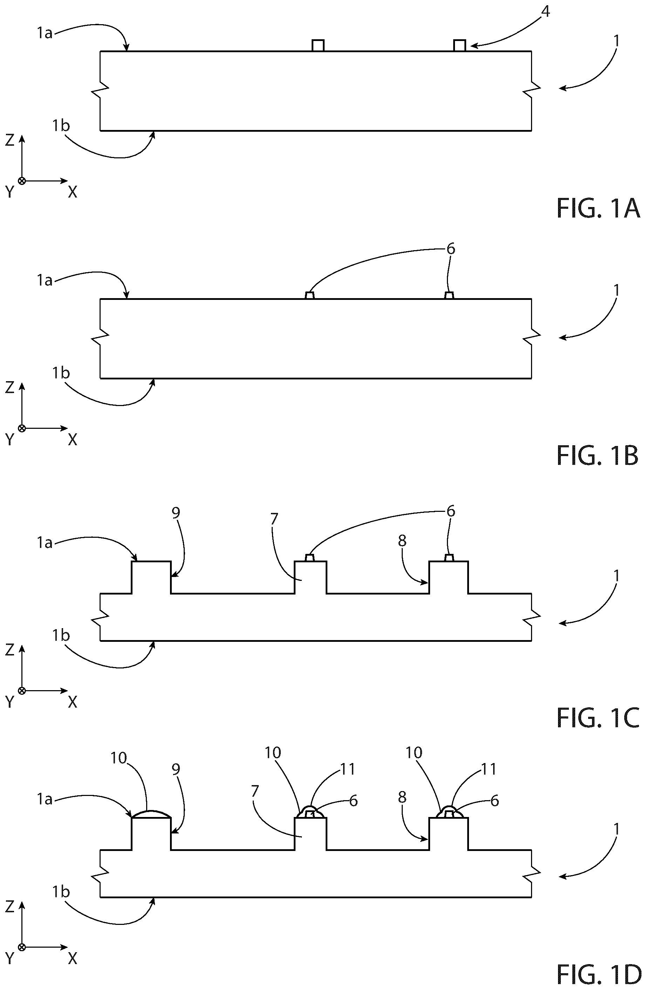

In this regard, Figure 1A shows a cap wafer 1, of semiconductor material, in particular silicon, having a first main surface 1a, with extension parallel to a horizontal plane xy, and a second main surface 1b, with extension in a respective horizontal plane, parallel to the aforementioned first main surface 1a and separated from this first main surface 1a along a vertical axis z (which defines a three-dimensional Cartesian reference system with the horizontal plane xy).

The manufacturing process initially envisages (as a first processing step of the aforementioned cap) forming a raised frame on the first main surface 1a of the cap wafer 1, around the position which will subsequently be occupied by a first cavity associated with a first microelectromechanical structure of the combined MEMS device. In particular, this first microelectromechanical structure (for example defining a gyroscope) has the requirement of a lower operating pressure with respect to at least one other microelectromechanical structure of the same combined MEMS device.

In detail, the first step of the manufacturing process, shown in the aforementioned Figure 1A, provides for forming an etching mask 4, so-called "hard mask", on the aforementioned first main surface 1a. This hard mask 4 is for example defined by forming a silicon oxide (for example TEOS) layer on the first main surface 1a, with an oxidation process and subsequent patterning of the same silicon oxide layer through wet etching.

Through the hard mask 4, the first main surface 1a of the cap wafer 1 is subject to a wet etching with an anisotropic etching solution (for example with TMAH, Tetramethylammonium Hydroxide).

As shown in Figure 1B, after this etching, a raised frame 6 is formed, where the hard mask 4 was located, above the aforementioned first main surface 1a, having for example a height comprised between 3 µm and 5 µm along the vertical axis z.

As will also be discussed below, this raised frame 6 has a ring shape, for example a square, rectangular or generally polygonal ring shape, in a section parallel to the horizontal plane xy.

It is underlined that Figure 1B (as well as the other Figures) shows only a portion of the cap wafer 1, dedicated to the formation of what will be a first combined MEMS device; clearly, the cap wafer 1 is intended, through sawing operations, to define a plurality of combined MEMS devices, so that a plurality of raised frames 6, one for each of said combined MEMS devices, are generally formed in this step of the manufacturing process above the first main surface 1a.

As shown in Figure 1C, the manufacturing process then envisages formation in the cap wafer 1, by means of a dry etching starting from the first main surface 1a, of the aforementioned first cavity, here denoted with 8 (designed to be associated with the first microelectromechanical structure of the combined MEMS device, for example defining a gyroscope); and furthermore of a second cavity 9 (designed to be associated with a second microelectromechanical structure of the combined MEMS device, for example defining an accelerometer).

As previously noted, the first microelectromechanical structure is configured to operate at a pressure having a different value, in particular a lower value, with respect to an operating pressure of the second microelectromechanical structure.

The first and second cavities 8, 9 extend throughout a desired depth (for example equal to 30 µm) along the vertical axis z inside the cap wafer 1 and are arranged side by side and separated in the horizontal plane xy by separation portions 7 of the same cap wafer 1.

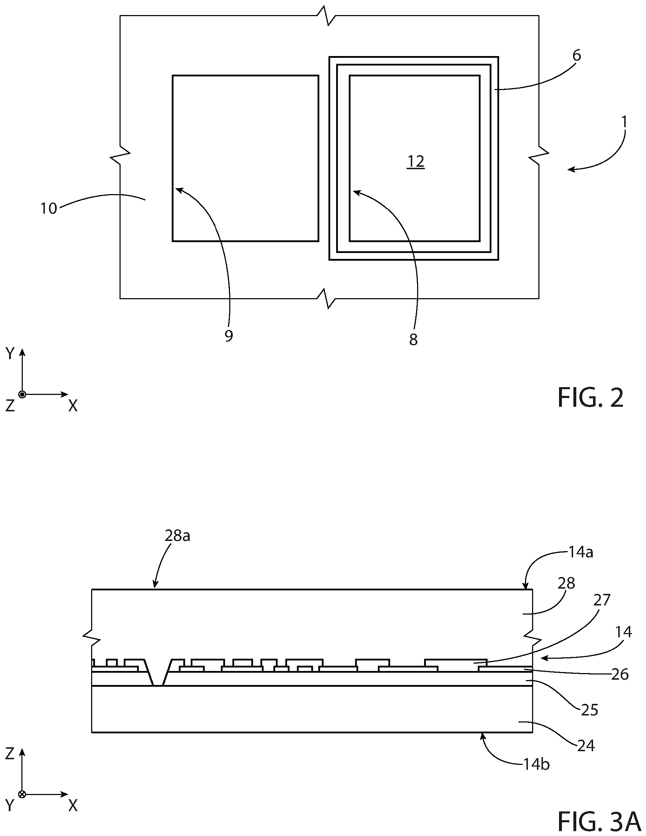

In particular, as also shown in the schematic layout of Figure 2, the first cavity 8 is formed internally to the aforementioned raised frame 6, which completely surrounds the same first cavity 8 in the horizontal plane xy. Conversely, the second cavity 9 is not surrounded by a raised frame (apart from a possible side in common with the aforementioned first cavity 8, in the event that the separation portion 7 has a small width in the horizontal plane xy).

In a manner not illustrated here, structural elements, such as for example stoppers or the like, may possibly be defined, through the aforementioned dry etching, inside the first and/or second cavities 8, 9.

As shown in Figure 1D, the process then envisages deposition, on the first main surface 1a of the cap wafer 1, of a bonding region 10, of a suitable material for ensuring a hermetic coupling, in particular of a paste of glassy material, so-called "glass frit".

This bonding region 10 (as also shown in Figure 2) is deposited at the lateral walls of the first and second cavities 8, 9, to completely surround the same first and second cavities 8, 9, thus assuming for example a square, rectangular or generally polygonal ring shape, in the horizontal plane xy, around these first and second cavities 8, 9, as also illustrated in the aforementioned Figure 2.

In particular, the bonding region 10 is deposited, around the first cavity 8, on the raised frame 6, which has previously been formed, assuming a shape that follows and replicates the shape of the underlying raised frame 6.

Consequently, around the aforementioned first cavity 8, the bonding region 10 has a raised portion 11 (arranged directly above the aforementioned raised frame 6) and therefore has an overall height, along the vertical axis z, greater than the height that the bonding region 10 assumes around the second cavity 9.

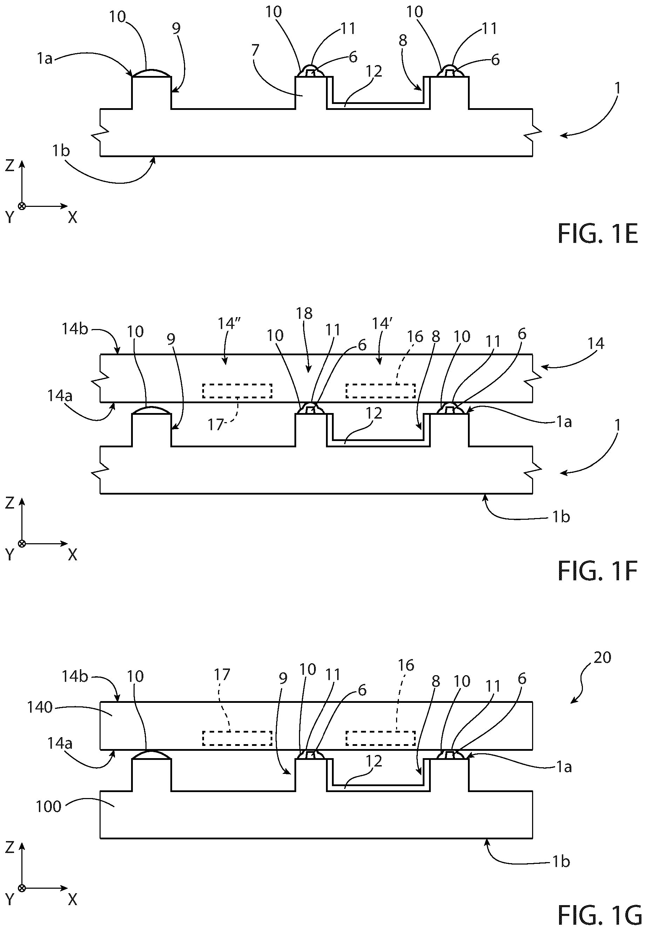

Afterwards, as shown in Figure 1E, a getter region 12 is formed inside the first cavity 8 (this getter region 12 being confined in the first cavity 8 and not being present in the second cavity 9). The getter region may be made of mixed oxides, by way of example zirconium oxide.

Subsequently, as shown in Figure 1F, the manufacturing process envisages bonding by thermocompression in the direction of the vertical axis z of the cap wafer 1 to a sensor wafer 14, where the aforementioned first and second microelectromechanical structures have previously been formed, in a manner not described in detail herein.

For example, the combined MEMS device defines an inertial measuring unit, the first microelectromechanical structure is a sensing structure defining a capacitive gyroscope, for example of the triaxial type; and the second microelectromechanical structure is a sensing structure defining a capacitive accelerometer, for example also of the triaxial type.

The sensor wafer 14, of semiconductor material, for example silicon, has a respective first main surface 14a, with an extension parallel to the horizontal plane xy, and a second main surface 14b, with an extension in a respective horizontal plane, parallel to the aforementioned first main surface 14a and separated from the first main surface 14a along the vertical axis z.

The respective first main surface 14a faces the first main surface 1a of the sensor wafer 1 in the aforementioned bonding between the sensor wafer 14 and the cap wafer 1.

The first and second microelectromechanical structures, indicated schematically by 16, 17 in Figure 1F, are formed respectively in a first and in a second portion 14', 14" of the sensor wafer 14, at the first main surface 14a, distinct from each other and separated by a separation portion 18 of the same sensor wafer 14.

In particular, the first microelectromechanical structure 16, after the aforementioned bonding of the cap wafer 1 to the sensor wafer 14, is arranged at the first cavity 8; similarly, the second microelectromechanical structure 17 is arranged at the second cavity 9. In a per se known manner, the first and second cavities 8, 9 contribute to forming housing cavities in which mobile elements, for example inertial masses, of the aforementioned first and second microelectromechanical structures 16, 17, are free to move.

According to one aspect of the present solution, the aforementioned bonding of the cap wafer 1 and the sensor wafer 14 is achieved in two steps, due to the presence of the raised frame 6 and the configuration of the bonding region 10 with the raised portion 11 at the same raised frame 6.

As shown in the aforementioned Figure 1F, in a first step, bonding occurs only at this raised frame 6, due to the fact that the first main surface 14a of the sensor wafer 14 first comes into contact with the raised portion 11 of the bonding region 10.

Consequently, hermetic closure (sealing) of the first cavity 8 is obtained and the getter region 12 is activated in the hermetic environment inside the same first cavity 8, when the second cavity 9 is still open (the bonding around the same second cavity 9 having not yet occurred).

Advantageously, interference, cross-talk phenomena, between the first and second cavities 8, 9 are thus avoided; in other words, the aforementioned getter region 12 contributes to controlling the pressure value inside the first cavity 8, but in this case does not affect the pressure value inside the second cavity 9.

Only in a second step of the aforementioned bonding, when the first cavity 8 has already been subject to hermetic closure and the desired pressure value therein has been determined due to the action of the aforementioned getter region 12, the first main surface 14a of the sensor wafer 14 comes into contact with the portions of the bonding region 10 arranged around the second cavity 9.

As shown in Figure 1G, the hermetic closure of the second cavity 9 thus also occurs (with the pressure value in the hermetic environment inside the same second cavity 9 being determined exclusively by the operating environment in which the bonding process is performed, without being affected by the aforementioned getter region 12), with the complete sealing of both cavities of the combined MEMS device.

For example, the pressure of the environment in which the bonding process is performed has a high value, suitable for the operation of the accelerometer defined by the second microelectromechanical structure 17, for example of the order of thousands of Pa, for example equal to 0.01 Mpa.

The manufacturing process terminates with sawing of the stack defined by the bonding of the cap wafer 1 and the sensor wafer 14, for the formation of the combined MEMS devices, one of which is shown and indicated by 20 in the aforementioned Figure 1G.

In particular, the combined MEMS device 20 comprises a sensor die 140 thus advantageously having therein both the first and the second microelectromechanical structures 16, 17; and moreover a cap 100 coupled to the sensor die 140, having the respective first and second cavities 8, 9 which contribute to defining the hermetic environment for the aforementioned first and second microelectromechanical structures 16, 17, set to a first and, respectively, second pressure, having values which are different and optimized for the respective operation.

A different embodiment of the process for manufacturing the combined MEMS device is now described, wherein the aforementioned raised frame 6 is formed not on the cap wafer 1, but on the sensor wafer 14.

In this regard, Figure 3A shows an already advanced step of the process for manufacturing the aforementioned sensor wafer 14 (here shown in greater detail with respect to the preceding Figures).

In particular, this sensor wafer 14 comprises a substrate 24 having an upper surface 24a, having a dielectric layer 25 formed thereon and above which the aforementioned first and second microelectromechanical structures 16, 17 will be formed.

A conductive layer 26, for example of polysilicon, is arranged and suitably patterned on the dielectric layer 25, defining suitable electrical connections between the first and second microelectromechanical structures 16, 17 and contact pads, accessible from the outside of the combined MEMS device (not illustrated here), for example for biasing the same structures and for acquiring the corresponding sensing signals.

A sacrificial layer 27, of a dielectric material, is suitably patterned on the conductive layer 26; a structural layer 28, for example of epitaxially grown polysilicon, is formed above this sacrificial layer 27. An upper surface 28a of this structural layer 28, arranged at a distance from the substrate 24, defines the aforementioned respective main surface 14a of the sensor wafer 14, designed to face the cap wafer 1 after bonding.

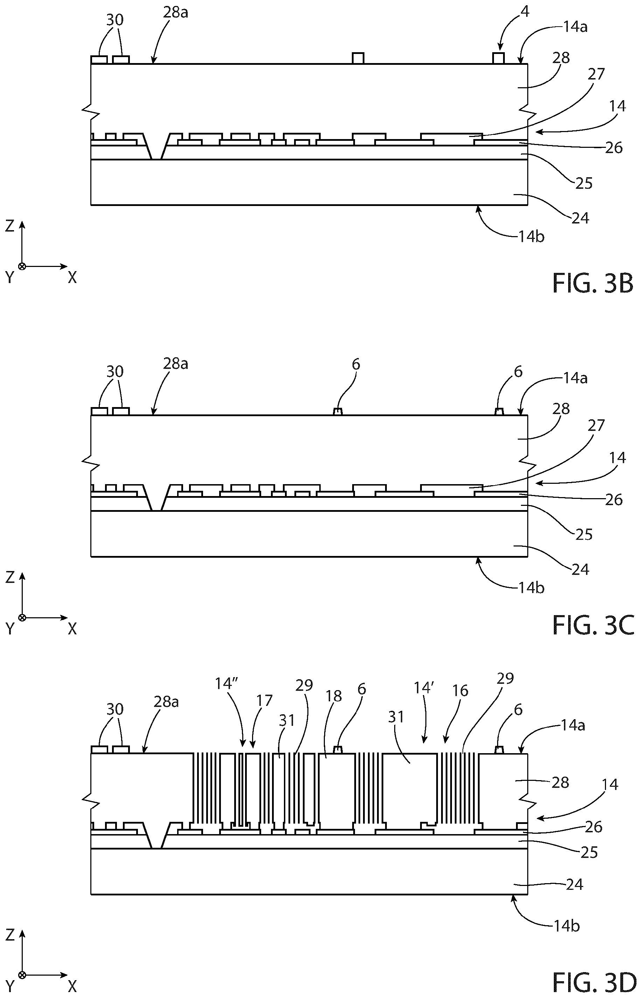

As shown in the same Figure 3B, a metal layer has been previously deposited and patterned (for example by wet etching) above the upper surface 28a for forming the aforementioned contact pads, indicated here by 30, in an external position in the horizontal plane xy with respect to the region that will be occupied by the aforementioned first and second microelectromechanical structures 16, 17.

According to an aspect of the present embodiment, as shown in Figure 3B, the hard mask, again indicated by 4, is therefore in this case formed on the aforementioned upper surface 28a of the structural layer 28.

As shown in Figure 3C, through the hard mask 4, the upper surface 28a of the structural layer 28 of the sensor wafer 14 is then subjected to a wet etching with an anisotropic etching solution (for example with TMAH, tetramethylammonium hydroxide).

Following this etching, the raised frame, again indicated by 6, is formed where the hard mask 4 was located.

As shown in Figure 3D, a trench etching is performed at this point through the entire thickness of the structural layer 28, which also entails removal of a large part of the underlying sacrificial layer 27.

Formation is thereby completed of the first and second microelectromechanical structures 16, 17, which comprise, defined in the same structural layer 28, respective suspended elements, indicated schematically by 29 (for example inertial masses, sensing electrodes and/or actuation electrodes, elastic elements); these suspended elements 29 are coupled to respective anchoring elements 31, integral with the substrate 24, also defined starting from the same structural layer 28.

The aforementioned separation portion 18 of the sensor wafer 14 comprises, in the illustrated example, a portion of the aforementioned structural layer 28.

In this case, the raised frame 6 therefore directly surrounds the first microelectromechanical structure 16 in the horizontal plane xy, having a (square, rectangular or generally polygonal) ring shape.

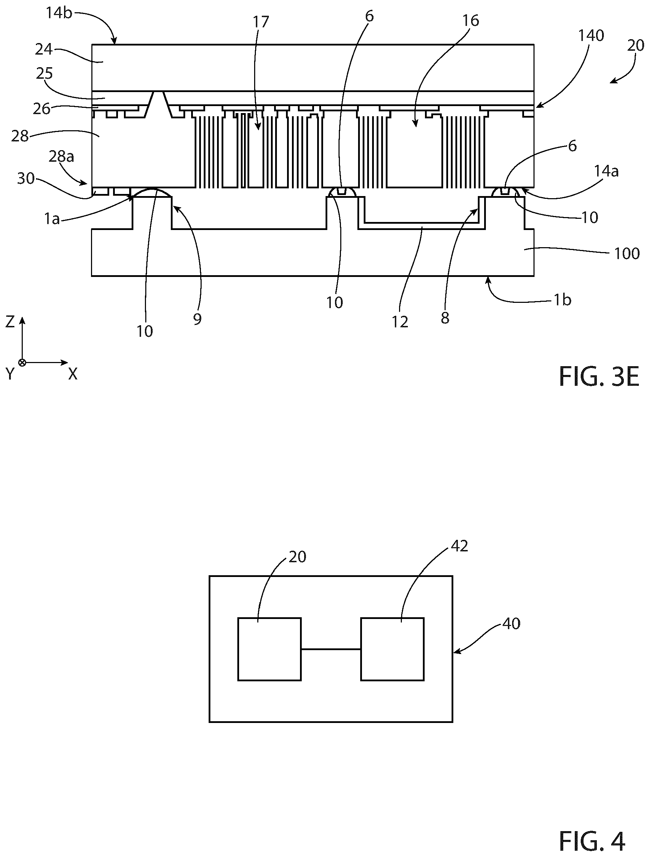

The manufacturing process then proceeds with the bonding of the sensor wafer 14 to the cap wafer 1, as illustrated in Figure 3E.

This cap wafer 1 has previously been processed for forming, as previously discussed, the first and second cavities 8, 9 and for forming the getter region 12 inside the first cavity 8 (unlike what has previously been discussed, the processing of the cap wafer 1 does not envisage definition of the raised frame).

Moreover, the bonding region 10 has already been deposited on the first main surface 1a of the cap wafer 1, completely surrounding both the first cavity 8 and the second cavity 9.

Also in this case, similarly to what has previously been discussed, the bonding process provides for a first step, wherein the bonding region 10 initially comes into contact with the raised frame 6, therefore initially determining sealing of the first cavity 8 and activation of the getter region 12; and a second step, wherein the same bonding region 10 comes into contact with the upper surface 28a of the structural layer 28 around the second cavity 9 and therefore determines sealing also of this second cavity 9.

The manufacturing process ends, as previously discussed, with sawing of the stack formed by the sensor wafer 14 and the cap wafer 1, for the definition of the individual combined MEMS devices 20, each of which comprises a sensor die 140 and also a cap 100 coupled to the sensor die 140 (as shown in the aforementioned Figure 3E).

The advantages of the present solution are clear from the preceding description.

In any case, it is highlighted that the described solution allows a reduction (in particular, a substantial elimination) of the cross-talk between the microelectromechanical structures 16, 17 of the combined MEMS device 20, without requiring substantial changes to the manufacturing process flow. In general, the solution described requires in fact adding a single hard mask for definition of the raised frame 6 at the first cavity 8 associated with the first microelectromechanical structure 16.

The described process is therefore simple and inexpensive to implement, not requiring complex and expensive additional process steps to achieve different pressure values for the hermetic cavities of the microelectromechanical structures 16, 17 of the combined MEMS device 20.

The discussed solution is advantageously applicable in an electronic apparatus, for example of a portable type (such as a smartphone, a tablet, a smart watch), as indicated schematically in Figure 4.

The electronic apparatus, indicated by 40, comprises the combined MEMS device 20, acting for example as an inertial measuring unit, and a control unit 42, operatively coupled to the combined MEMS device 40 for receiving sensing signals provided by the same combined MEMS device 20, for controlling general operation of the electronic apparatus 40.

Finally, it is clear that modifications and variations may be made to what has been described and illustrated without thereby departing from the scope of the present invention, as defined in the attached claims.

In particular, it is underlined that the described solution may find advantageous application in all MEMS devices in which it is required to provide at least two structures having respective distinct hermetic cavities in which a different pressure value is to be defined (for example, the solution may be applied to the case of combined MEMS devices including two accelerometers or two gyroscopes and/or any other hermetic cavity structures, for example a microphone or a pressure sensor).

## Claims

1. A process for manufacturing a combined microelectromechanical device (20), comprising:
forming in a sensor wafer (14) of semiconductor material having a main surface (14a) at least a first (16) and a second (17) microelectromechanical structures, at said main surface (14a) ;
forming in a cap wafer (1) having a respective main surface (1a) at least a first (8) and a second (9) cavities, at said respective main surface (1a);
forming a getter region (12) in a localized manner inside said first cavity (8);
bonding the respective main surfaces (14a, 1a) of said sensor wafer (14) and of said cap wafer (1) in a facing position by means of an interposed bonding region (10), so that said first and second cavities (8, 9) define a first and a second hermetic environment respectively for said first and said second microelectromechanical structures (16, 17), set to a first, respectively second, pressure values, different from each other, wherein said getter region (12) contributes to definition of the first pressure value inside the first hermetic environment defined by the first cavity (8),
**characterized by** comprising, before said bonding step, forming a raised frame (6) so that it is located around said first cavity (8); wherein during the bonding step, said bonding region (10) determines bonding of said sensor wafer (14) to said cap wafer (1) at said raised frame (6) and definition of the first hermetic environment associated with said first cavity (8), in a time interval prior to hermetic closure of the second cavity (9).

2. The process according to claim 1, comprising forming the bonding region (10) to completely surround both the first cavity (8) and the second cavity (9); wherein said bonding step comprises a first phase, wherein the bonding region (10) determines the hermetic closure of said first cavity (8) and the consequent activation of the getter region (12) ; and a second phase, successive in time to the first phase, wherein said bonding region (10) brings said respective main surfaces (14a, 1a) into contact around said second cavity (9), determining its hermetic closure and the definition of the second hermetic environment.

3. The process according to claim 1 or 2, wherein the second pressure value inside the second hermetic environment defined by the second cavity (9) is greater than the first pressure value inside the first hermetic environment defined by the first cavity (8).

4. The process according to claim 3, wherein said second pressure value is defined solely by the pressure of an operating environment associated with said bonding step.

5. The process according to any of the preceding claims, wherein said raised frame (6) is formed by etching of the cap wafer (1) via a mask (4) on said main surface (1a), in such a way as to be located around said first cavity (8).

6. The process according to claim 5, comprising forming said bonding region (10) around the first cavity (8) at least in part above the raised frame (6); said bonding region (10) thus having, around said first cavity (8), a configuration having a raised portion (11) arranged on said raised frame (6) and an overall height along a vertical axis (z) orthogonal to said main surface (1a) of said cap wafer (1), greater than the height that the bonding region (10) assumes around the second cavity (9).

7. The process according to any of claims 1-4, wherein said raised frame (6) is formed by etching of the sensor wafer (14) via a mask (4) on the main surface (14a), in such a way as to be located around said first sensing structure (16).

8. The process according to claim 7, wherein said sensor wafer (14) comprises a substrate (24) and a structural layer (28) above said substrate (24), having an upper surface (28a) which defines said respective main surface (14a) of the sensor wafer (14); wherein said raised frame (6) is formed on said upper surface (28a) of said structural layer (28) and the step of forming said second sensing structure (17) comprises etching said structural layer (28) starting from said upper surface (28a), internally to said raised frame (6), to form suspended elements (29) above said substrate (24).

9. The process according to any of the preceding claims, wherein said bonding region (10) comprises glass frit material.

10. The process according to any of the preceding claims, wherein said first microelectromechanical structure (16) defines a gyroscopic sensor and said second microelectromechanical structure (17) defines an accelerometer sensor.

11. A combined microelectromechanical device (20), comprising:
a sensor die (140) of semiconductor material, having a main surface (14a) and integrating at least a first (16) and a second (17) microelectromechanical structures at said main surface (14a);
a cap (100), having a respective main surface (1a), at which at least a first (8) and a second (9) cavities are formed, a getter region (12) being arranged in a localized manner inside said first cavity (8);
wherein the respective main surfaces (14a, 1a) of the sensor die (140) and of the cap (100) are bonded in a facing position by means of an interposed bonding region (10), so that said first and second cavities (8, 9) define at least a first and a second hermetic environments respectively for said first and said second microelectromechanical structures (16, 17), set to a first, respectively second, pressure values, different from each other,
**characterized by** further comprising a raised frame (6), located around the first cavity (8); wherein said bonding region (10) is interposed between the main surfaces (14a, 1a) of the sensor die (14) and of the cap (1) at said raised frame (6) to define said first hermetic environment associated with said first cavity (8).

12. The device according to claim 11, wherein said bonding region (10) completely surrounds both the first cavity (8) and the second cavity (9).

13. The device according to claim 11 or 12, wherein said bonding region (10) comprises a portion (11) interposed, around said first cavity (8), between said raised frame (6) and one between the main surface (14a) of the sensor die (14) and the main surface (1a) of the cap (1).

14. The device according to any of claims 11-13, wherein said bonding region (10) comprises glass frit material.

15. The device according to any of claims 11-14, wherein said first microelectromechanical structure (16) defines a gyroscopic sensor and said second microelectromechanical structure (17) defines an accelerometer sensor; and wherein the second pressure value inside the second hermetic environment defined by the second cavity (9) is greater than the first pressure value inside the first hermetic environment defined by the first cavity (8).
